(19) **Europäisches Patentamt / European Patent Office / Office européen des brevets**

(11) **EP 3 159 372 A1**

(12) # EUROPEAN PATENT APPLICATION
published in accordance with Art. 153(4) EPC

(43) Date of publication:
**26.04.2017 Bulletin 2017/17**

(21) Application number: **15809116.5**

(22) Date of filing: **16.06.2015**

(51) Int Cl.:
*C08J 5/18* (2006.01)     *C03C 27/12* (2006.01)
*C08J 3/16* (2006.01)     *C08L 29/14* (2006.01)
*C08L 51/04* (2006.01)     *H01L 31/048* (2014.01)

(86) International application number:
**PCT/JP2015/067369**

(87) International publication number:
**WO 2015/194574 (23.12.2015 Gazette 2015/51)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **17.06.2014 JP 2014124721**

(71) Applicants:
• **Mitsubishi Rayon Co., Ltd.**
  **Tokyo 100-8253 (JP)**
• **Kuraray Co., Ltd.**
  **Kurashiki-shi, Okayama 710-0801 (JP)**

(72) Inventors:
• **MATSUNAGA, Yosuke**
  **Otake-shi**
  **Hiroshima 739-0694 (JP)**

• **KIURA, Masaaki**
  **Otake-shi**
  **Hiroshima 739-0694 (JP)**
• **NODONO, Mitsufumi**
  **Otake-shi**
  **Hiroshima 739-0694 (JP)**
• **YASUDA, Hirotaka**
  **Kurashiki-shi**
  **Okayama 713-8550 (JP)**
• **MUGURUMA, Shinichi**
  **Kurashiki-shi**
  **Okayama 713-8550 (JP)**

(74) Representative: **Müller-Boré & Partner**
**Patentanwälte PartG mbB**
**Friedenheimer Brücke 21**
**80639 München (DE)**

(54) ## RUBBER-CONTAINING GRAFT POLYMER POWDER, SOLAR CELL SEALING MATERIAL CONTAINING SAME, AND INTERLAYER FOR LAMINATED GLASS

(57)     An object of the present invention is to provide a film having excellent transparency, corrosion resistance, adhesive properties, and economic property. Another object of the present invention is to provide a rubber-containing graft polymer powder to be contained in the film.

Provided is a film comprising: a resin composition comprising polyvinyl acetal and a rubber-containing graft polymer powder having a refractive index of 1.469 to 1.519; 0 to 100 ppm of calcium ions; and 1 to 1100 ppm of alkali metal ions and alkali earth metal ions in total.

EP 3 159 372 A1

**Description**

TECHNICAL FIELD

The present invention relates to a rubber-containing graft polymer powder, an encapsulant for a solar cell containing the rubber-containing graft polymer powder and polyvinyl acetal, and a solar cell module using the encapsulant. In addition, the present invention relates to an interlayer film for laminated glass containing a rubber-containing graft polymer powder and a polyvinyl acetal resin, and laminated glass using the interlayer film.

BACKGROUND ART

In recent years, from the viewpoint of the effective use of resources or the prevention of environmental pollution, solar cells that convert sunlight directly into electric energy have been widely used, and further development is underway.
As solar cells, a crystalline silicon solar cell, thin film-based silicon, a cadmium telluride solar cell, a CIGS solar cell, a CIS solar cell and the like are exemplified. These solar cells generally have a configuration in which a surface side protective member such as a glass substrate, a solar cell, a back surface side protective member and the like are encapsulated via an encapsulant, are further reinforced by a frame and then constructed.
As a raw material of the encapsulant, it has been proposed to use a polyvinyl butyral (PVB) resin of a thermoplastic resin (see Patent Literatures 1 and 2). The PVB resin is a thermoplastic resin, and thus the resin is highly viscous at the flow beginning temperature and it is less concerned that the resin flows out through the end of glass to contaminate an apparatus or the end surface of the glass when conducting lamination. In addition, from the mechanical point of view as well, an encapsulant using the PVB resin is excellent in adhesive property to glass and penetration resistance. Furthermore, the encapsulant does not require a cross-linking step, and thus it is possible to manufacture a solar cell module by a roll-to-roll process.
However, the encapsulant described in Patent Literatures 1 and 2 generally contains a great amount of a plasticizer as an essential component in addition to PVB in order to improve handling property when winding around a roll and the like. The moisture permeability of the encapsulant is likely to increase by this plasticizer, and thus the solar cell module is discolored by the corrosion of the metal component and the power generation efficiency thereof decreases in some cases when used for a long period of time under a high temperature and a high humidity. Meanwhile, there is a problem that handling property or impact resistance is insufficient when the amount of the plasticizer is decreased in order to reduce the corrosion resistance.
Hitherto, a waterproof sealing treatment to encapsulate the ends of the solar cell module with an encapsulant and to cover the solar cell module with a frame has been provided in order to prevent such a decrease in power generation efficiency. The price of the frame is generally about 2 to 4 times as much as the encapsulant, and thus frameless construction is significantly useful for the cost reduction of a solar cell and investigations have been carried out. As one of the means to achieve it, an encapsulant having improved corrosion resistance is desired. However, the current frameless module does not exhibit sufficient impact resistance, and thus the back surface is necessary to have a reinforced structure, and as a result, expensive thermally tempered glass is used and additional cost reduction remains as a problem to be solved. In addition, a further improvement in durability is desired.
In laminated glass using PVB in an interlayer film as well, the corrosion of the functional material by an acidic component is similarly a problem in some cases in a case in which a functional material such as a thermal barrier material and an electrochromic material is concurrently used, and thus an interlayer film for laminated glass having improved corrosion resistance is desired.
Under such circumstances, a resin composition for laminated glass using a rubber-containing graft polymer powder is known (for example, Patent Literatures 3 and 4). However, the interlayer film for laminated glass or encapsulant for a solar cell using a rubber which is disclosed in Patent Literature 3 still has room for improvement in transparency and corrosion resistance. Furthermore, the resin composition for laminated glass containing an acrylic rubber-containing graft polymer powder disclosed in Patent Literature 4 has room for improvement in corrosion resistance and has an insufficient adhesive property. In addition, since an encapsulant is used on the light-receiving surface side in a crystalline silicon solar cell, CIGS and CIS solar cells in many cases, a high light transmittance (to be excellent in transparency) is one of the important performances required.

CITATION LIST

PATENT LITERATURE

Patent Literature 1: JP 2006-13505 A
Patent Literature 2: WO 2009/151952 A
Patent Literature 3: WO 2012/026393 A
Patent Literature 4: JP 2003-40654 A

## SUMMARY OF INVENTION

### TECHNICAL PROBLEM

An object of the present invention is to provide a film having excellent transparency, corrosion resistance, adhesive property, and economic property. Another object of the present invention is to provide a rubber-containing graft polymer powder to be contained in the film.

### SOLUTION TO PROBLEM

The present invention relates to a film containing: a resin composition containing polyvinyl acetal and a rubber-containing graft polymer powder having a refractive index of 1.469 to 1.519; 0 to 100 ppm of calcium ions; and 1 to 1100 ppm of alkali metal ions and alkali earth metal ions in total.

In the present invention, further, it is preferable that content of the rubber-containing graft polymer powder is 1 to 100 parts by mass relative to 100 parts by mass of the polyvinyl acetal in the resin composition.

In the present invention, further, it is preferable that the resin composition further contains magnesium salts.

In the present invention, further, it is preferable that content of the calcium ions in the rubber-containing graft polymer powder is 0 to 1000 ppm.

In addition, the present invention relates to a resin composition for a film in which a difference in refractive index is ±0.02 or less between polyvinyl acetal and a rubber-containing graft polymer powder, wherein the resin composition contains 0 to 100 ppm of calcium ions and 1 to 1100 ppm of a total of alkali metal ions and alkali earth metal ions.

In addition, the present invention relates to a rubber-containing graft polymer powder for a polyvinyl acetal resin film which has calcium ion content of 0 to 750 ppm and a refractive index of 1.469 to 1.519.

In the present invention, further, it is preferable that the rubber-containing graft polymer powder for a polyvinyl acetal resin film is obtained by coagulating a rubber-containing graft polymer latex, which is obtained by graft polymerization of a vinyl monomer (Y) in the presence of a rubbery polymer (X), using a coagulant containing at least one selected from an inorganic acid, an organic acid, an alkali metal salt of an inorganic acid or an organic acid, and an aluminum salt of an inorganic acid or an organic acid, and then by recovering it.

In the present invention, further, it is preferable that the rubbery polymer (X) contains a conjugated diene unit (x1).

In the present invention, further, it is preferable that the rubbery polymer (X) contains 25 to 75% by mass of a conjugated diene unit (x1), 75 to 25% by mass of an acrylic acid alkyl ester unit (x2) having an alkyl group with 2 to 8 carbon atoms, and 0 to 5% by mass of other copolymerizable monomer unit (x3).

In the present invention, further, it is preferable that the vinyl monomer (Y) contains 50 to 100% by mass of a methyl methacrylate (y1) and 50 to 0% by mass of an acrylic acid alkyl ester having an alkyl group with 1 to 8 carbon atoms and/or styrene (y2).

In the present invention, further, it is preferable that the rubber-containing graft polymer powder for a polyvinyl acetal resin film is obtained by graft polymerization of 10 to 1000 parts by mass of the vinyl monomer (Y) in the presence of 100 parts by mass of a polymer solid matter of the rubbery polymer (X).

In addition, the present invention relates to a resin composition containing the rubber-containing graft polymer powder for a polyvinyl acetal resin film and polyvinyl acetal.

In addition, the present invention relates to a film containing the resin composition.

In addition, the present invention relates to an interlayer film for laminated glass or an encapsulant for a solar cell having the film.

In addition, the present invention relates to a laminated glass or a photovoltaic module which is prepared with the interlayer film for laminated glass or encapsulant for a solar cell.

### ADVANTAGEOUS EFFECTS OF INVENTION

According to the present invention, a film having excellent transparency, corrosion resistance, adhesive property, and economic property can be provided. Furthermore, a rubber-containing graft polymer powder to be contained in the film can be also provided.

BRIEF DESCRIPTION OF DRAWINGS

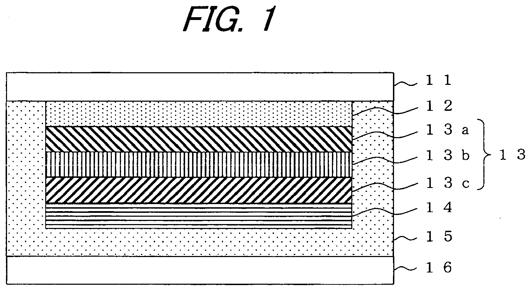

Fig. 1 is an exemplary cross-sectional view of a silicone solar cell module of common thin film type.

DESCRIPTION OF EMBODIMENTS

[Rubbery polymer]

A rubbery polymer (X) in the present invention is not particularly limited, and it is preferable to use a thermoplastic elastomer. As for the thermoplastic elastomer, various copolymerization resins are used. Based on the reason related to easy control of refractive index, impact strength, or the like, the rubbery polymer (X) is preferably one obtained by polymerization of a monomer (x) containing conjugated diene. From the viewpoint of obtaining the rubbery polymer (X) with excellent impact strength and weather resistance, the rubbery polymer (X) is more preferably one obtained by polymerizing the monomer (x) containing conjugated diene and an acrylic acid alkyl ester having an alkyl group with 2 to 8 carbon atoms. Furthermore, the carbon atom number of the alkyl group is more preferably 4 to 8. In addition, the monomer (x) may contain, other than the conjugated diene and acrylic acid alkyl ester having an alkyl group with 2 to 8 carbon atoms, other monomer which is copolymerizable with those monomers.

Examples of the conjugated diene include 1,3-butadiene, isoprene, 1,3-pentadiene, 2,3-dimethylbutadiene, 2-methyl-1,3-pentadiene, 3-methyl-1,3-pentadiene, 1,3-hexadiene, 2,4-hexadiene, 2-ethyl-1,3-butadiene, 2-phenyl-1,3-butadiene, 1-phenyl-1,3-butadiene, 1,3-diphenyl-1,3-butadiene, 1,4-diphenyl-1,3-butadiene, 2,3-diphenylbutadiene and 1,3-cyclohexadiene.

Examples of the acrylic acid alkyl ester having an alkyl group with 2 to 8 carbon atoms may include ethyl acrylate, propyl acrylate, butyl acrylate, isopropyl acrylate, hexyl acrylate and 2-ethylhexyl acrylate. As the acrylic acid alkyl ester having an alkyl group with 2 to 8 carbon atoms, one kind may be used singly or two or more kinds may be used in combination. In particular, butyl acrylate and 2-ethylhexyl acrylate are preferable from the perspective of improvement of weather resistance for the resulted film and ease of the adjustment of refractive index of the rubber-containing graft polymer powder.

Examples of the other monomer which is copolymerizable with the conjugated diene or acrylic acid alkyl ester having an alkyl group with 2 to 8 carbon atoms include a monofunctional monomer such as a methacrylic acid alkyl ester including methyl methacrylate or acrylonitrile, and a multifunctional monomer such as divinyl benzene, ethylene glycol dimethacrylate, butylene glycol diacrylate, triallyl cyanurate, triallyl isocyanurate, trimethylolpropane triacrylate and pentaerythritol tetraacrylate. As the copolymerizable other monomer, one kind may be used singly or two or more kinds may be used in combination.

The composition of the rubbery polymer (X) preferably contains a conjugated diene unit (x1). Preferably, it contains the conjugated diene unit (x1) at 25 to 75% by mass, the acrylic acid alkyl ester unit (x2) having an alkyl group with 2 to 8 carbon atoms at 75 to 25% by mass, and the copolymerizable other monomer unit (x3) at 0 to 5% by mass when the total amount of the rubbery polymer (X) is 100% by mass. More preferably, it contains the conjugated diene unit (x1) at 30 to 70% by mass, the acrylic acid alkyl ester unit (x2) having an alkyl group with 2 to 8 carbon atoms at 70 to 30% by mass, and the copolymerizable other monomer unit (x3) at 0 to 5% by mass. Still more preferably, it contains the conjugated diene unit (x1) at 35 to 65% by mass, the acrylic acid alkyl ester unit (x2) at 65 to 35% by mass, and the copolymerizable other monomer unit (x3) at 0 to 5% by mass. It is possible to obtain a film excellent in impact resistance and weather resistance, as the composition is within the above range.

The rubbery polymer (X) can be obtained by a known emulsion polymerization method. For example, it may be obtained by setting the temperature of a mixture of the monomer (x), an emulsifier, and water to a predetermined temperature and then adding a polymerization initiator thereto.

As the emulsifier, a known emulsifier can be used, and it is preferable to use a fatty acid-based emulsifier. For the rubber-containing graft polymer powder described hereinbelow, it is important to select the emulsifier and a coagulant such that the salt formed from the emulsifier remaining in the rubber-containing graft polymer latex and the coagulant used for coagulation is hardly ionized when coagulating the rubber-containing graft polymer latex.

Examples of the fatty acid-based emulsifier include sodium N-lauroylsarcosinate, fatty acid potassium such as potassium octanoate, potassium decanoate, potassium laurate, or potassium palmitate, fatty acid sodium such as sodium octanoate, sodium decanoate, sodium laurate, or sodium palmitate, dipotassium alkenyl succinate, and rosin acid soap. The emulsifier may be used either singly or in combination of two or more types. Among them, it is preferable to use, in particular, sodium N-lauroylsarcosinate from the viewpoint of easy handling, easy availability, or the like.

As the polymerization initiator, a thermal decomposition type initiator such as potassium persulfate and ammonium persulfate or a redox type initiator that is a combination of an organic peroxide such as cumene hydroperoxide, t-butyl hydroperoxide and diisopropylbenzene hydroperoxide, an iron compound, sodium ethylenediamine tetraacetate and sodium formaldehyde sulfoxylate is used. It is also possible to use sodium pyrophosphate instead of sodium ethylenediaminetetraacetate and dextrose instead of sodium formaldehyde sulfoxylate.

A chain transfer agent such as mercaptan may be used at the time of polymerization for the purpose of, for example, adjusting the molecular weight.

The rubbery polymer (X) may be obtained in latex form, and the volume average particle diameter of rubbery polymer latex is preferably within the range of from 0.12 to 0.60 $\mu$m, and more preferably from 0.15 to 0.50 $\mu$m. When the volume average particle diameter of the rubbery polymer latex is within this range, it is possible to obtain a film which is excellent in impact resistance and has a favorable appearance. The method for measuring the volume average particle diameter is not particularly limited, but it is convenient to measure the volume average particle diameter by a dynamic light scattering method or a turbidimetric method.

[Enlarged rubbery polymer latex]

By obtaining an enlarged rubbery polymer latex with enlarged particles according to addition of an enlarging agent to the rubbery polymer latex which is obtained by emulsion polymerization of the monomer (x), it is possible to set the volume average particle diameter of the rubber-containing graft polymer powder within a preferred range.

The enlarging agent can be arbitrarily selected from those which are known, but it is preferable to use an acid group-containing copolymer latex and/or an oxyacid salt.

As the acid group-containing copolymer, those obtained by polymerizing acrylic acid alkyl ester, unsaturated acid, or other copolymerizable monomer are preferable.

As the acrylic acid alkyl ester used for the polymerization of the acid group-containing copolymer, at least one acrylic acid alkyl ester in which the alkyl group has 1 to 12 carbon atoms is preferable, and it is more preferable that the alkyl group has 2 to 8 carbon atoms. Specific example of the acrylic acid alkyl ester used for polymerization of an acid group-containing copolymer include methyl acrylate, ethyl acrylate, propyl acrylate, butyl acrylate, isopropyl acrylate, hexyl acrylate, 2-ethylhexyl acrylate, and stearyl acrylate.

The unsaturated acid used for the polymerization of the acid group-containing copolymer, for example, consists of at least one kind selected from acrylic acid, methacrylic acid, itaconic acid, crotonic acid, maleic acid, fumaric acid, cinnamic acid, sorbic acid and p-styrene sulfonic acid. Among these, acrylic acid and methacrylic acid are preferable from the viewpoint of easy availability and easy handling.

Examples of the other copolymerizable monomer may include a styrene derivative such as styrene and $\alpha$-methyl styrene and acrylonitrile.

As the proportion of the monomers used in the acid group-containing copolymer, it is preferable that the unsaturated acid is from 3 to 40% by mass, the acrylic acid alkyl ester unit is from 97 to 35% by mass and the other copolymerizable monomer is from 0 to 40% by mass when the total amount of the monomers used in the acid group-containing copolymer is 100% by mass, and it is more preferable that the unsaturated acid is from 5 to 35% by mass, the acrylic acid alkyl ester is from 95 to 30% by mass and the other copolymerizable monomer is from 0 to 35% by mass. As the composition of the monomer used for polymerizing the acid group-containing copolymer is within the above range, excellent stability of the rubbery polymer latex is exhibited when conducting enlargement and it is easy to control the volume average particle diameter of the rubbery polymer (X) obtained by the enlargement.

The acid group-containing copolymer latex can be obtained by polymerizing a monomer mixture having the above composition by a known emulsion polymerization method.

The oxyacid salt which may be used as an enlarging agent is preferably an alkali metal salt or alkali earth metal salt of oxyacid containing an element which is selected from the element group belonging to the second and third periods of Group IIIB to Group VIB in the periodic table of the elements, or at least one or more kinds of oxyacid salts selected from a zinc salt, a nickel salt and an aluminum salt. Examples of such an oxyacid salt may include salts of sulfuric acid, nitric acid, phosphoric acid, and the like with potassium, sodium, magnesium, calcium, nickel and aluminum. As the oxyacid salt, sodium sulfate, potassium sulfate, magnesium sulfate, aluminum sulfate, sodium phosphate, magnesium phosphate and the like are preferable from the viewpoint of easy controllability of the particle diameter at the time of conducting enlargement, easy availability, and easy handling.

As each of these acid group-containing copolymer latex and oxyacid salt, one kind may be used singly or two or more kinds may be used in combination.

The addition amount of the acid group-containing copolymer latex is preferably from 0.1 to 5 parts by mass, and more preferably from 0.5 to 3 parts by mass per 100 parts by mass of the rubbery polymer (X). In addition, the addition amount of the oxyacid salt is preferably from 0.1 to 5 parts by mass, and more preferably from 0.1 to 4 parts by mass per 100 parts by mass of the rubbery polymer (X). As the acid group-containing copolymer latex and/or the oxyacid salt are added within these ranges, the enlargement of the particle of the rubbery polymer latex is more efficiently conducted and the stability of the enlarged rubbery polymer latex to be obtained is also greatly improved.

The pH of the rubbery polymer latex is preferably 7 or more in the case of conducting the enlargement treatment using the acid group-containing copolymer latex. In a case in which the pH value is at acidic side, the enlargement efficiency may be low even when the acid group-containing copolymer latex is added and thus it may not be possible to advantageously produce the composition intended by the present invention in some cases.

The volume average particle diameter of the enlarged rubbery polymer latex obtained is preferably within the range of from 0.12 to 0.60 $\mu$m, and more preferably from 0.15 to 0.50 $\mu$m. It is possible to obtain a film which is excellent in impact resistance and has a favorable appearance when the volume average particle diameter of the enlarged rubbery polymer latex is within this range. The method for measuring the volume average particle diameter is not particularly limited, but it is convenient to measure the volume average particle diameter by a dynamic light scattering method or a turbidimetric method.

[Rubber-containing graft polymer latex]

The rubber-containing graft polymer latex is one obtained by the graft polymerization of a vinyl monomer (Y) in the presence of the rubbery polymer (X). Specifically, the rubber-containing graft polymer latex can be obtained, for example, by the graft polymerization of a vinyl monomer (Y) in the presence of the rubbery polymer latex or the enlarged rubbery polymer latex.

The vinyl monomer (Y) used in the graft polymerization can be appropriately selected depending on the glass transition temperature or refractive index of the rubber-containing graft polymer. It is preferable to use a monomer mixture containing methyl methacrylate (y1), and an acrylic acid alkyl ester having an alkyl group with 1 to 8 carbon atoms and/or styrene (y2) from the viewpoint of easy handling and ease of adjustment of the refractive index. Furthermore, the alkyl group of the alkyl acrylic acid ester more preferably has carbon atom number of from 1 to 4.

As the composition of the monomer mixture, it is preferable to contain methyl methacrylate (y1) at 50 to 100% by mass and the acrylic acid alkyl ester having an alkyl group with 1 to 8 carbon atoms and/or styrene (y2) at 50 to 0% by mass per 100% by mass of the monomer constituting the graft part. It is more preferable to contain methyl methacrylate (y1) at 60 to 90% by mass and the acrylic acid alkyl ester having an alkyl group with 1 to 8 carbon atoms and/or styrene (y2) at 40 to 10% by mass. As these monomers, one kind can be used singly or two or more kinds may be used in combination. The acrylic acid alkyl ester having an alkyl group with 1 to 8 carbon atoms and/or styrene (y2) may be used for the purpose of adjusting refractive index of the rubber-containing graft polymer powder. Specifically, because the homopolymer of the methyl methacrylate (y1) has a refractive index of 1.489, it is preferable to have copolymerization with an acrylic acid alkyl ester having an alkyl group with 1 to 8 carbon atoms, if it is desired to have lower refractive index (for example, refractive index of a homopolymer of ethyl acrylate is 1.4865). If it is desired to have higher refractive index, it is preferable to have copolymerization with styrene (refractive index of a homopolymer of styrene is 1.592). It is possible to obtain a rubber-containing graft polymer powder which is excellent in transparency as the composition is within the above range.

Specific examples of the acrylic acid alkyl ester having an alkyl group with 1 to 8 carbon atoms may include methyl acrylate, ethyl acrylate, propyl acrylate, butyl acrylate, isopropyl acrylate, hexyl acrylate, 2-ethylhexyl acrylate and the like. Among these, methyl acrylate, ethyl acrylate and butyl acrylate are preferable from the viewpoint of ease of adjustment of the refractive index and easy availability.

The rubber-containing graft polymer latex is preferably the one which is obtained by graft polymerization of 10 to 1,000 parts by mass of the vinyl monomer (Y) in the presence of 100 parts by mass of polymer solid matter of the rubbery polymer (X). It is more preferably the one which is obtained by graft polymerization of 20 to 800 parts by mass of the vinyl monomer (Y). Fluidity and processability become favorable as the vinyl monomer (Y) is 10 parts by mass or more and a rubber-containing graft polymer powder excellent in impact resistance is obtained as the vinyl monomer (Y) is set to be 1000 parts by mass or less.

The rubber-containing graft polymer latex can be obtained by a known emulsion polymerization method. For example, the rubber-containing graft polymer latex may be obtained by preparing a latex phase according to addition of an emulsifier in the presence of the rubbery polymer (X) and performing polymerization with addition a mixture of the vinyl monomer (Y) and a polymerization initiator while maintaining a pre-determined temperature. As the emulsifier, a known emulsifier can be used like the emulsifier for polymerization of the rubbery polymer (X). Furthermore, the same polymerization initiator as the one used for polymerizing the rubbery polymer (X) may be used as a polymerization initiator. A chain transfer agent such as mercaptan may be used at the time of polymerization for the purpose of, for example, adjusting the molecular weight.

The volume average particle diameter of the rubber-containing graft polymer latex obtained by the graft polymerization of the vinyl monomer (Y) in the presence of the rubbery polymer latex or the enlarged rubbery polymer latex is preferably from 0.13 to 0.80 $\mu$m, and more preferably from 0.15 to 0.70 $\mu$m from the viewpoint of improving impact resistance. As the method for measuring the volume average particle diameter, for example, a method by a dynamic light scattering method or a turbidimetric method is convenient.

[Rubber-containing graft polymer powder]

In the present invention, the rubber-containing graft polymer powder indicates powder of rubber-containing graft polymer latex which is obtained by graft polymerization of the vinyl monomer (Y) in the presence of the rubbery polymer (X). It is obtained by, for example, coagulating a rubber-containing graft polymer latex followed by dehydration, washing and drying.

The rubber-containing graft polymer powder has a refractive index of from 1.469 to 1.519. From the viewpoint of enhancing the transparency, it is preferably 1.469 to 1.509, more preferably 1.474 to 1.504, and still more preferably 1.479 to 1.499. When the refractive index of the rubber-containing graft polymer powder is less than 1.469 or more than 1.519, the transparency is impaired, and the adaptability to a transparent member tends to be lowered.

As a method for adjusting the refractive index of the rubber-containing graft polymer powder to 1.469 to 1.519, there can be a method of adjusting the rubbery polymer (X) or the acrylic acid alkyl ester and/or styrene and the like used for the graft part to have a suitable composition.

In order to recover the rubber-containing graft polymer powder from the latex obtained after completion of the graft polymerization, an additive such as an antioxidant is added to the latex if necessary and the latex is coagulated by a known method which uses an aqueous solution of a coagulant.

The coagulant for coagulating the rubber-containing graft polymer latex is not particularly limited, and a coagulant containing at least one selected from an inorganic acid, an organic acid, or an alkali metal salt of an inorganic acid or an organic acid, an alkali earth metal salt of an inorganic acid or an organic acid, and an aluminum salt of an inorganic acid or an organic acid is used. Examples of the inorganic acid include sulfuric acid, hydrochloric acid, phosphoric acid, and nitric acid. Examples of the organic acid include acetic acid and oxalic acid. Examples of the alkali metal salt of an inorganic acid include sodium sulfate, potassium sulfate, sodium nitrate, potassium nitrate, monosodium phosphate, disodium phosphate, and trisodium phosphate. Examples of the alkali metal salt of an organic acid include sodium acetate and potassium acetate. Examples of the alkali earth metal salt of an inorganic acid include calcium chloride, magnesium chloride, calcium sulfate, magnesium sulfate, calcium nitrate, and magnesium nitrate. Examples of the alkali earth metal salt of an organic acid include calcium acetate and magnesium acetate. Examples of the aluminum salt of an inorganic acid include aluminum chloride, aluminum sulfate, aluminum monophosphate, aluminum diphosphate, and aluminum triphosphate. Examples of the aluminum salt of an organic acid include aluminum acetate. Among them, from the viewpoint of reducing the calcium ion amount contained in the rubber-containing graft polymer, it is preferable to use a coagulant which is selected from an inorganic acid, an organic acid, or an alkali metal salt of an inorganic acid or an organic acid, and an aluminum salt of an inorganic acid or an organic acid. Furthermore, from the viewpoint of easy obtainability of the coagulant, it is more preferable to use a coagulant which contains sulfuric acid. By using a coagulant which contains sulfuric acid, more favorable properties of the rubber-containing graft polymer after being prepared in powder form can be obtained. Meanwhile, as long as it is within the range in which the effect of the present invention is not adversely affected, it is also possible to use in combination an alkali earth metal salt of an organic acid or an alkali earth metal salt of an inorganic acid. The coagulant may be used either singly or in combination of two or more types. To suppress the eluted amount of an acidic component eluted after a hot water test, it is possible to use a method of washing sufficiently the salts or ions during the washing step, in addition to selecting a combination of an emulsifier and a coagulant such that the salt to be produced is hardly ionized.

In the washing step, it is preferable to wash the powder obtained with deionized water of 5 times or more and preferably 10 times or more as much as the mass of the powder. It is possible to sufficiently wash the salts and the ions formed in the coagulating step and to suppress the formation of an acid by conducting the washing with deionized water of 5 times or more as much as the mass of the powder.

Washing with deionized water may be conducted after conducting the preliminary washing with an aqueous solution of sodium carbonate, sodium acetate, sodium hydrogen carbonate, sodium hydrogen phosphate, potassium hydrogen carbonate, dipotassium hydrogen phosphate, ammonium hydrogen carbonate or the like for the purpose of removing the remaining ions and maintaining the pH of the powder to be weakly alkaline.

From the viewpoint of further improving the impact resistance of the film of the present invention, the glass transition temperature of the rubber-containing graft polymer powder is preferably -10°C or lower, more preferably -20°C or lower, and still more preferably -30°C or lower. The lower limit of the glass transition temperature of the rubber-containing graft polymer powder is not particularly limited, but the glass transition temperature of the rubber-containing graft polymer powder is preferably -200°C or higher, and more preferably -150°C or higher. As the method for measuring the glass transition temperature, the glass transition temperature can be measured from the peak value of tan $\delta$ on the basis of JIS K 7244: 1999.

The transparency of the film is also important in the case of using the film of the present invention as an interlayer film for laminated glass of the present invention in an architectural application or as an encapsulant for a solar cell. From the viewpoint of maintaining the transparency of the film, the difference in refractive index between the rubber-containing graft polymer powder and the polyvinyl acetal resin is preferably $\pm 0.02$ or less, more preferably $\pm 0.01$ or less, and still more preferably ±0.005 or less. Hence, it is important to properly adjust the refractive index by copolymerizing an acrylic acid alkyl ester and/or styrene and the like in the graft polymerization step so that the rubber-containing graft polymer powder has a refractive index within a desired range.

From the viewpoint of improving the impact resistance of the film of the present invention, the content of the rubber-containing graft polymer powder in the resin composition constituting the film is preferably from 1 to 100 parts by mass, more preferably from 3 to 80 parts by mass, and still more preferably from 5 to 60 parts by mass with respect to 100 parts by mass of the polyvinyl acetal resin. The effect of improving impact resistance tends to decrease when the content of the rubber-containing graft polymer powder is less than 1 part by mass. On the other hand, when the content of the rubber-containing graft polymer powder is more than 100 parts by mass, there is a tendency that the adhesive force with the glass decreases or the fluidity of the encapsulant for a solar cell or the interlayer film for glass to be obtained decreases and thus lamination becomes difficult. The addition amount of the rubber-containing graft polymer powder may be appropriately selected depending on the composition of the polyvinyl acetal resin to be used, the average degree of polymerization and the like.

Content of calcium ions in the rubber-containing graft polymer powder is, from the viewpoint of enhancing the adhesive property or corrosion resistance, preferably 0 to 1000 ppm, more preferably 0 to 750 ppm, still more preferably 0 to 500 ppm, and particularly preferably 0 to 400 ppm. As a method for having the calcium ions in the rubber-containing graft polymer powder within the above range, there is a method of selecting an emulsifier for polymerization or a coagulant for coagulation that is not a calcium salt, or a method of fully washing the salts or ions during the washing step for coagulation.

[Polyvinyl acetal]

The content ratio of polyvinyl acetal in the film of the present invention is preferably 40% by mass or more, more preferably 50% by mass or more, and still more preferably 60% by mass or more. Corrosion resistance or adhesive property tends to be insufficient when the content ratio of polyvinyl acetal is less than 40% by mass. In addition, it is also possible to mix an inorganic substance (titanium oxide, talc and the like).

As the polyvinyl acetal, those having an average degree of acetalization of from 40 to 90% by mole are preferable. It is not preferable that the average degree of acetalization be less than 40% by mole since the water absorption ratio of the film increases. It takes a long reaction time for obtaining polyvinyl acetal and thus it may not be preferable regarding the reaction process in some cases if the average degree of acetalization is more than 90% by mole. The average degree of acetalization is more preferably from 60 to 85% by mole, and still more preferably from 65 to 80% by mole from the viewpoint of water resistance. The average degree of acetalization is based on the vinyl acetal component in polyvinyl acetal described hereinbelow.

As the polyvinyl acetal, those which contain a vinyl acetate component in polyvinyl acetal at 20% by mole or less are preferable, those which contain a vinyl acetate component at 5% by mole or less are more preferable, and those which contain a vinyl acetate component at 2% by mole or less are still more preferable. It is not preferable that the vinyl acetate component be more than 20% by mole since blocking is caused at the time of producing polyvinyl acetal to have difficulty in producing and also there is a possibility that the acetate group is converted into a carboxyl group by hydrolysis under a high temperature and a high humidity condition.

Polyvinyl acetal is usually composed of a vinyl acetal component, a vinyl alcohol component and a vinyl acetate component, and the amount of each of these components can be measured, for example, based on the "Polyvinyl Butyral Test Method" of JIS K 6728: 1977 or a nuclear magnetic resonance (NMR) method.

In a case in which the polyvinyl acetal contains a component other than the vinyl acetal component, the amount of the vinyl acetal component of the remainder can be calculated usually by measuring the amount of the vinyl alcohol component and the amount of the vinyl acetate component and subtracting the amounts of these two components from the total amount of polyvinyl acetal.

As polyvinyl acetal used in the present invention, it is possible to use those obtained by reacting an aldehyde described hereinbelow with polyvinyl alcohol. Such polyvinyl acetal can be produced by a known method.

Polyvinyl alcohol used as a raw material of polyvinyl acetal can be obtained, for example, by polymerizing a vinyl ester-based monomer and saponifying the polymer obtained. As the method for polymerizing the vinyl ester-based monomer, it is possible to apply a method known in the art such as a solution polymerization method, a bulk polymerization method, a suspension polymerization method and an emulsion polymerization method. As the polymerization initiator, an azo-based initiator, a peroxide-based initiator, a redox-based initiator and the like are appropriately selected depending on the polymerization method. As the saponification reaction, it is possible to apply alcoholysis, hydrolysis and the like which are known in the art and use an alkali catalyst or an acid catalyst, and among these, a saponification reaction to use methanol as a solvent and a caustic soda (NaOH) catalyst is simple and thus it is most preferable.

It is preferable to set the amount of vinyl acetate in polyvinyl acetal to be obtained to be within the above range, and thus the degree of saponification of polyvinyl alcohol to be a raw material is preferably 80% by mole or more, more preferably 95% by mole or more, and still more preferably 98% by mole or more.

Examples of the vinyl ester-based monomer may include vinyl formate, vinyl acetate, vinyl propionate, vinyl butyrate, vinyl isobutyrate, vinyl pivalate, vinyl versatate, vinyl caproate, vinyl caprylate, vinyl laurate, vinyl palmitate, vinyl stearate, vinyl oleate, vinyl benzoate and the like. In addition, it is also possible to copolymerize the vinyl ester-based monomer with another monomer such as $\alpha$-olefin within a range in which the gist of the present invention is not impaired in the case of polymerizing the vinyl ester-based monomer.

As the polyvinyl alcohol used as a raw material of polyvinyl acetal, those having an average degree of polymerization of from 100 to 5000 are preferable, those having an average degree of polymerization of from 400 to 3000 are more preferable, those having an average degree of polymerization of from 600 to 2500 are still more preferable, those having an average degree of polymerization of from 700 to 2300 are particularly preferable, and those having an average degree of polymerization of from 750 to 2000 are most preferable. When the average degree of polymerization of polyvinyl alcohol is too low, there are some cases in which the penetration resistance and creep resistance property, particularly creep resistance property under a high temperature and high humidity condition such as 85°C and 85% RH of the film to be obtained decrease. On the other hand, when the average degree of polymerization is more than 5000, there are some cases in which molding of the film is difficult. In addition, in order to improve the lamination suitability of the film to be obtained and to obtain a film superior in appearance, the average degree of polymerization of polyvinyl alcohol is preferably 1500 or less, more preferably 1100 or less, and still more preferably 1000 or less in a system to which a plasticizer is not added. In addition, it is preferable to use polyvinyl alcohol having a higher average degree of polymerization in a system to which a plasticizer is added, and the average degree of polymerization is preferably 2500 or less, and more preferably 2000 or less. The average degree of polymerization of polyvinyl acetal is consistent with the average degree of polymerization of polyvinyl alcohol of a raw material, and thus the preferred average degree of polymerization of polyvinyl alcohol described above is consistent with the preferred average degree of polymerization of polyvinyl acetal.

The average degree of polymerization of polyvinyl alcohol can be measured, for example, based on the "Polyvinyl Alcohol Test Method" of JIS K 6726.

The solvent used in the production of polyvinyl acetal is not particularly limited, but it is preferable to use water regarding the industrial mass production, and it is preferable to sufficiently dissolve polyvinyl alcohol under a high temperature, for example, a temperature of 90°C or higher in advance prior to the reaction. In addition, the concentration of the aqueous solution in which polyvinyl alcohol is dissolved is preferably from 5 to 40% by mass, more preferably from 6 to 20% by mass, and still more preferably from 7 to 15% by mass. The productivity is poor when the concentration of the aqueous solution in which polyvinyl alcohol is dissolved is too low. On the other hand, it is not preferable that the concentration of the aqueous solution be too high since stirring during the reaction is difficult and gelation by the intermolecular hydrogen bond of polyvinyl alcohol occurs, and thus an uneven reaction takes place.

The polyvinyl acetal can be produced by adding aldehydes to an aqueous solution of polyvinyl alcohol to be subjected to a reaction. A catalyst used here may be either an organic acid or an inorganic acid, and examples thereof may include acetic acid, p-toluene sulfonic acid, hydrochloric acid, nitric acid, sulfuric acid, carbonic acid and the like. Among these, hydrochloric acid, nitric acid and sulfuric acid are preferable since a sufficient reaction rate is achieved and washing after the reaction is easy, and nitric acid is more preferable due to easy handling property. The concentration of the catalyst in the aqueous solution of polyvinyl alcohol after the addition of the catalyst is preferably from 0.01 to 5 mol/L, and more preferably from 0.1 to 2 mol/L in the case of hydrochloric acid, sulfuric acid and nitric acid although it may vary depending on the kind of the catalyst used. It is not preferable that the concentration of the catalyst be too low since the reaction rate is slow and thus it takes time to obtain polyvinyl acetal having an intended degree of acetalization and intended physical properties. On the other hand, it is not preferable that the concentration of the catalyst be too high since a trimer of the aldehyde is easily formed as well as it is difficult to control the acetalization reaction.

Here, as the aldehydes, for example, formaldehyde, acetaldehyde, propionaldehyde, butyraldehyde, hexyl aldehyde, benzaldehyde and the like are used. An aldehyde compound having from 1 to 12 carbon atoms is preferable, a saturated alkyl aldehyde compound having from 1 to 6 carbon atoms is more preferable and a saturated alkyl aldehyde compound having from 1 to 4 carbon atoms is even more preferable. Among them, butyl aldehyde is preferable from the viewpoint of the mechanical properties of the film. In addition, one kind of aldehydes may be used singly or two or more kinds thereof may be used in combination. In particular, it is preferable to use butyraldehyde and acetaldehyde in combination from the viewpoint that the glass transition temperature of polyvinyl acetal can be controlled. Furthermore, a small amount of polyfunctional aldehydes or other aldehydes having a functional group may be used in combination within a range of 20% by mass or less of the total aldehydes.

As a reaction order for the acetalization, a known method may be exemplified, and examples thereof may include a method in which the catalyst is added to the aqueous solution of polyvinyl alcohol and the aldehydes are then added and a method in which the aldehydes are added first and the catalyst is then added. In addition, a method in which the aldehydes or catalyst to be added is added at once, sequentially or in a divided manner or a method in which a mixed solution of the aqueous solution of polyvinyl alcohol and the aldehydes or the catalyst is added to the solution containing the catalyst or the aldehydes may be also exemplified.

The reaction temperature of the acetalization reaction is not particularly limited, but it is preferable to conduct the reaction at a relatively low temperature of from 0 to 40°C and it is more preferable to conduct the reaction at from 5 to 20°C until the particles of polyvinyl acetal are precipitated in the middle of the reaction from the viewpoint of producing porous polyvinyl acetal to be easily washed after the reaction in order to improve the corrosion resistance of the film. It is concerned that polyvinyl acetal is fused and becomes hardly porous when the reaction temperature is higher than 40°C. After the reaction is conducted at a relatively low temperature of from 0 to 40°C, it is preferable to raise the reaction temperature to from 50 to 80°C and it is more preferable to raise it to from 65 to 75°C in order to increase the productivity by accelerating the reaction.

As the method for removing the aldehydes and the catalyst that remain after the acetalization reaction, a known method is exemplified. Polyvinyl acetal obtained by the reaction is neutralized by an alkali compound, but it is preferable to remove the aldehydes remaining in polyvinyl acetal as much as possible prior to the neutralization. For this reason, a method to accelerate the reaction under the condition that increase the reaction rate of the aldehydes, a method to sufficiently wash with water, a mixed solvent of water/alcohol or the like and a method for chemically treating the aldehyde are useful. Examples of the alkali compound used for the neutralization may include an alkali metal hydroxide such as sodium hydroxide and potassium hydroxide or an amine-based compound such as ammonia, trimethylamine and pyridine. Among these, an alkali metal hydroxide which has less influence on the adhesive property with glass is even more preferable.

Polyvinyl acetal obtained by the method described above is decomposed by an acid in the presence of water to produce aldehydes and thus it is preferable to adjust the alkali titer value to be a positive value. The alkali titer value of polyvinyl acetal after the alkali neutralization is preferably from 0.1 to 30, more preferably from 1 to 20, and still more preferably from 1 to 10. It is concerned that the hydrolysis easily proceeds when the alkali titer value is less than 0.1, and conversely it is concerned that the coloration easily occurs at the time of manufacturing a film of polyvinyl acetal when the alkali titer value is more than 30. Here, the alkali titer value is the quantity (mL) of 0.01 mol/L hydrochloric acid required to neutralize and titrate the alkali component in 100 g of polyvinyl acetal by neutralization.

The acid value of polyvinyl acetal obtained by the method described above is preferably 0.50 KOHmg/g or less, more preferably 0.30 KOHmg/g or less, still more preferably 0.10 KOHmg/g or less and particularly preferably 0.06 KOHmg/g or less. When the acid value of polyvinyl acetal is more than 0.50 KOHmg/g, the coloration caused by a great amount of the acidic component may occur in the film to be obtained. Furthermore, if the film in which the acid value of polyvinyl acetal is more than 0.50 KOHmg/g is used for a solar cell module, the electrode of the solar cell module may corrode to yield a decrease in service life of the solar cell module. Here, the acid value of polyvinyl acetal is a value measured in accordance with JIS K6728: 1977.

[Resin composition]

In the present invention, the resin composition contains the rubber-containing graft polymer powder and polyvinyl acetal.

[Other additives]

The resin composition containing the rubber-containing graft polymer powder and polyvinyl acetal, which is used for the film of the present invention, may further contain a plasticizer, an adhesive force modifier, an antioxidant, an ultraviolet absorber, a light stabilizer, a blocking inhibitor, a pigment, a dye, a functional inorganic compound and the like if necessary within the range in which the effect of the present invention is not impaired.

In a case in which the film of the present invention contains a plasticizer, the content thereof is preferably from 0 to 80 parts by mass or less with respect to 100 parts by mass of polyvinyl acetal. The plasticizer is mainly used for the purpose to improve fluidity and impact resistance. It is not preferable that the plasticizer is more than 80 parts by mass since the mechanical properties of the film are impaired and the handling is difficult. In addition, it is not preferable since it is concerned that the amount of the acidic component contained as an impurity in the plasticizer increases in the application as an encapsulant for a solar cell or the moisture permeability increases by the plasticizing effect so as to allow water to easily infiltrate and thus a problem such as a decrease in power or discoloration of the solar cell module under a high temperature and a high humidity occurs. Hence, in the application as an encapsulant for a solar cell, the content of the plasticizer is preferably 60 parts by mass or less, more preferably 45 parts by mass or less, still more preferably 30 parts by mass or less and may be 0 part by mass (that is, a plasticizer may not be used) with respect to 100 parts by mass of polyvinyl acetal.

The acid value of the plasticizer is preferably 0.50 KOHmg/g or less, more preferably 0.30 KOHmg/g or less, still more preferably 0.10 KOHmg/g or less and particularly preferably 0.06 KOHmg/g or less. In a case in which the acid value of the plasticizer is more than 0.50 KOHmg/g, it is concerned that the film may be colored or produces a decomposed gas and thus the service life of the film to be obtained may be shortened or the long-term durability of the film may decrease. Here, the acid value of the plasticizer is a value measured in accordance with JIS K6728: 1977.

The plasticizer is not particularly limited, but examples thereof may include dicarboxylic acid diesters such as triethylene glycol di(2-ethylhexanoate) (3GO), tetraethylene glycol di(2-ethylhexanoate), di-(2-butoxyethyl) adipate (DBEA), di-(2-butoxyethyl) sebacate (DBES), di-(2-butoxyethyl) azelate, di-(2-butoxyethyl) glutarate, di-(2-butoxyethyl) phthalate, di-(2-butoxyethoxyethyl) adipate (DBEEA), di-(2-butoxyethoxyethyl) sebacate (DBEES), di-(2-butoxyethoxyethyl) azelate, di-(2-butoxyethoxyethyl) glutarate, di-(2-butoxyethoxyethyl) phthalate, di-(2-hexoxyethyl) adipate, di-(2-hexoxyethyl) sebacate, di-(2-hexoxyethyl) azelate, di-(2-hexoxyethyl) glutarate, di-(2-hexoxyethoxyethyl) adipate, di-(2-hexoxyethoxyethyl) sebacate, di-(2-hexoxyethoxyethyl) azelate, di-(2-hexoxyethoxyethyl) glutarate, or diisononyl 1,2-cyclohexanedicarboxylate (DINCH); glycerin ester like castor oil, polyester polyol or a diester thereof including a diol compound like 3-metyl-1,5-pentane diol and a dicarboxylic acid compound such as adipic acid; and polyalkylene glycol and a derivative thereof such as polyethylene glycol or polypropylene glycol or a derivative thereof (ester, ether, or the like). Among these, a plasticizer of which the sum of the number of carbon atoms and the number of oxygen atoms that constitute the molecule of the plasticizer is more than 28 is preferable. In particular, the acid value increases as the thermal decomposition or hydrolysis occurs under a high temperature and a high humidity when the sum of the number of carbon atoms and the number of oxygen atoms that constitute the molecule of the plasticizer is 28 or less and thus the concentration of the acid tends to increase in the film. Preferred examples thereof may include triethylene glycol di(2-ethylhexanoate) (3GO), tetraethylene glycol di(2-ethylhexanoate), di-(2-butoxyethoxyethyl) adipate (DBEEA), di-(2-butoxyethoxyethyl) sebacate (DBEES), diisononyl 1,2-cyclohexanedicarboxylate (DINCH) and the like. Among these, triethylene glycol di(2-ethylhexanoate) (3GO) and diisononyl 1,2-cyclohexanedicarboxylate (DINCH) are preferable from the viewpoint that it is possible to obtain the desired plasticizing effect by a small amount without decreasing the corrosion resistance of the film. One kind of such a plasticizer may be used singly or two or more kinds thereof may be used in combination.

As the adhesive force modifier, for example, those which are disclosed in WO 03/033583 can be used, and an alkali metal salt and an alkali earth metal salt are preferably used and examples thereof may include salts of potassium, sodium, magnesium and the like. Examples of the salt may include a salt of an organic acid such as carboxylic acid including octanoic acid, hexanoic acid, butyric acid, acetic acid and formic acid; and a salt of an inorganic acid such as hydrochloric acid and nitric acid. The optimal amount of the adhesive force modifier added varies depending on the additive used, but it is preferable that the adhesive force of the encapsulant for a solar cell or the interlayer film for laminated glass to be obtained to glass be adjusted to be generally from 3 to 10 in the pummel test (described in WO 03/033583 A and the like), to be from 3 to 6 particularly in a case in which high penetration resistance is required and to be from 7 to 10 in a case in which high glass shatterproof property is required. It is also a useful method that the adhesive force modifier is not added in a case in which high glass shatterproof property is required. In addition, a silane coupling agent is exemplified as various kinds of additives for improving the adhesive property of the encapsulant for a solar cell or the interlayer film for laminated glass with the glass. The addition amount of the silane coupling agent is preferably from 0.01 to 5% by mass on the basis of the mass of the encapsulant for a solar cell or the interlayer film for laminated glass.

Examples of the antioxidant may include a phenol-based antioxidant, a phosphorus-based antioxidant and a sulfur-based antioxidant, and among these, a phenol-based antioxidant is preferable and an alkyl-substituted phenol-based antioxidant is particularly preferable. These antioxidants may be used singly or in combination of two or more kinds thereof. The amount of the antioxidant blended is preferably from 0.001 to 5 parts by mass, and more preferably from 0.01 to 1 part by mass with respect to 100 parts by mass of polyvinyl acetal.

As the ultraviolet absorber, known ones can be used, and examples thereof may include a benzotriazole-based ultraviolet absorber, a triazine-based ultraviolet absorber and a benzoate-based ultraviolet absorber. The addition amount of the ultraviolet absorber is preferably from 10 to 50,000 ppm, and more preferably from 100 to 10,000 ppm by mass with respect to polyvinyl acetal. In addition, one kind of ultraviolet absorber may be used singly or two or more kinds thereof may be used in combination.

As the light stabilizer, a hindered amine-based light stabilizer, for example, "ADEKASTAB LA-57 (trade name)" manufactured by ADEKA CORPORATION is exemplified.

Examples of the functional inorganic compound may include a light reflective material, a light-absorbing material, a thermal conductivity improving material, an electric characteristic improving material, a gas barrier improving material and a mechanical property improving material.

[Film]

Content of the calcium ions in the film of the present invention is 0 to 100 ppm. It is preferably 0 to 85 ppm, and more preferably 0 to 70 ppm. By having the content of the calcium ions within this range, the adhesive property to glass and corrosion resistance can be enhanced. As a method for setting the content of the calcium ions to be within this range, there are method as follows - a method of adjusting washing conditions for preparing the rubber-containing graft polymer powder; and a method of selecting a coagulant (for example, a coagulant not containing calcium is used).

Content of the alkali metal ions and alkali earth metal ions in the film of the present invention is 1 to 1100 ppm in total. It is preferably 1 to 900 ppm, more preferably 5 to 700 ppm, and still more preferably 10 to 500 ppm. By having the content of the alkali metal ions and alkali earth metal ions to be within this range, acid generation is inhibited and the corrosion resistance can be enhanced. A method for setting the content of the alkali metal ions and alkali earth metal ions to be within this range includes: a method of adding an arbitrary amount of the alkali metal salts and alkali earth metal salts; and a method of using the polyvinyl acetal resin or rubber-containing graft polymer powder which contains a pre-determined amount of the alkali metal ions and alkali earth metal ions.

Furthermore, also from the viewpoint of suppressing the acid generation in the film, inhibiting discoloration at high temperature and high humidity, and having an adhesive property to glass, it is preferable that the film contains magnesium salts. Content of the magnesium salt is preferably 1 to 1000 ppm, more preferably 5 to 700 ppm, and still more preferably 10 to 500 ppm. As the magnesium salt, magnesium acetate is particularly preferable. Furthermore, at the time of adding the magnesium salts, it is also possible to add also an acid which can generate the magnesium salts based on a neutralization reaction (that is, acetic acid is also added at the time of adding magnesium acetate). In that case, the mass ratio between the magnesium salt and acid is preferably 100/0 to 50/50, and more preferably 100/0 to 70/30. When the mass ratio between the magnesium salt and acid is less than 50/50, there is a tendency of increasing amount of an acid generated in the film and easily having discoloration at high temperature and high humidity conditions.

The method for manufacturing a film of the present invention is not particularly limited, but it is possible to fabricate a film by containing a rubber-containing graft polymer powder at from 1 to 100 parts by mass with respect to 100 parts by mass of polyvinyl acetal, blending a predetermined amount of a plasticizer and/or other additives to it if necessary, uniformly kneading the mixture, and forming into a film by a known film forming method such as an extrusion method, a calender method, a pressing method, a casting method and an inflation method. It is also possible to use the obtained film as an encapsulant for a solar cell or as an interlayer film for laminated glass.

Among the known film forming methods, a method to manufacture a film using an extruder is especially suitably employed. The resin temperature during extrusion is preferably from 150 to 250°C, and more preferably from 170 to 230°C. When the resin temperature is too high, polyvinyl acetal will undergo decomposition and the content of volatile substances is likely to increase. On the contrary, when the resin temperature is too low, the content of volatile substances is likely to increase as well. In order to efficiently remove the volatile substances, it is preferable to remove the volatile substances from a vent port of the extruder by reducing the pressure.

In the film of the present invention, it is important that the content of chlorine is 50 ppm or less, preferably 30 ppm or less, more preferably 10 ppm or less, still more preferably 6 ppm or less, and most preferably 3 ppm or less with respect to the film. When the content of chlorine is more than 50 ppm, the discoloration of the solar cell module due to the corrosion of the metal component under a high temperature and a high humidity is likely to occur and the power of the solar cell module decreases as a result when the film is used as an encapsulant for a solar cell. Meanwhile, the lower limit value of the content of chlorine is not particularly limited, but it is 0.1 ppm from the perspective of the manufacturing method. As the method for measuring the content of chlorine, the content of chlorine can be measured by potentiometric titration in the same manner as Examples described hereinbelow. Specifically, the concentration of the chloride ion in the encapsulant for a solar cell or the interlayer film for laminated glass can be determined from the titer by a change in electrical conductivity using a 0.001 mol/L aqueous solution of silver nitrate as the titrant, and the concentration of the chloride ion can be used as the content of chlorine.

As described above, in order to set the content of chlorine in the film to be within the above range, for example, a method in which the content of chlorine in polyvinyl acetal to be used is lowered is exemplified, and specifically, a method in which a non-chlorine-based catalyst is used as the catalyst used for acetalizing polyvinyl alcohol with an aldehyde is exemplified. As the non-chlorine-based catalyst, those which are described above are used, but sulfuric acid or nitric acid is preferable since a sufficient reaction rate is obtained and the washing after the reaction is easy, and nitric acid is more preferable since handling property is especially easy. In addition, even in the case of using a chlorine-based catalyst such as hydrochloric acid, it is also possible to lower the content of chlorine by repeatedly washing polyvinyl acetal obtained by acetalization with water or the like after filtration and/or neutralization.

In a case in which the film of the present invention is used as an encapsulant for a solar cell or the interlayer film for laminated glass, it is preferable to form an uneven structure on the surface of the encapsulant for a solar cell or the interlayer film for laminated glass of the present invention by a method known in the art such as melt fracture and emboss. The shape of melt fracture and emboss is not particularly limited, and those which are known in the art can be employed.

The film thickness of the encapsulant for a solar cell is not particularly limited, but it is preferably from 20 to 10,000 $\mu$m, more preferably from 100 to 3,000 $\mu$m, and still more preferably from 200 to 1,000 $\mu$m. The film thickness of the interlayer film for laminated glass is not particularly limited, but it is preferably from 20 to 10,000 $\mu$m, and more preferably from 100 to 3,000 $\mu$m. It is not preferable that the film thickness of the encapsulant for a solar cell or the interlayer film for laminated glass be too thin since lamination cannot be successfully conducted when fabricating a solar cell module or laminated glass and it is not preferable that the film thickness of the encapsulant for a solar cell or the interlayer film for laminated glass be too thick due to the cost increase.

The encapsulant for a solar cell of the present invention in which the film of the present invention is used can be used as an encapsulant for forming a solar cell module by sealing between a solar cell and a surface side transparent protective member and/or a back surface side protective member. As such a solar cell module, a variety of types can be exemplified. Examples thereof may include those having a configuration in which the solar cell is sandwiched by an encapsulant on both sides as in surface side transparent protective member/surface encapsulant / solar cell /back encapsulant /back surface side protective member, those having a configuration of surface side transparent protective member/ solar cell / encapsulant /back surface side protective member (superstrate structure), and those having a configuration of surface side transparent protective member/ encapsulant / solar cell /back surface side protective member (substrate structure).

Examples of the solar cell constituting the solar cell module may include various solar cells such as a silicon-based solar cell including monocrystalline silicon, polycrystalline silicon and amorphous silicon, a compound semiconductor-based solar cell of elements of Group III to Group V or Group II to Group VI in the periodic table including gallium-arsenide, CIGS, and cadmium-telluride, and an organic solar cell including a dye-sensitized organic solar cell and an organic thin film solar cell.

For example, a solar cell module using thin film-based silicon as the solar cell may have a superstrate configuration in which a solar cell such as a silicon power generation element is encapsulated between a glass substrate 11 that is a surface side transparent protective member and a glass substrate 16 that is a back surface side protective member (back cover) via an encapsulant 15 containing polyvinyl butyral as illustrated in Fig. 1. Here, the solar cell refers to the portion consisting of a transparent electrode layer 12, a photoelectric conversion unit 13 and a back surface electrode 14. The photoelectric conversion unit 13 is configured, for example, by a p-layer amorphous Si film as a p-type layer 13a, an i-layer amorphous Si film as an i-type layer 13b and an n-layer amorphous Si film as an n-type layer 13c. Moreover, the encapsulant for a solar cell of the present invention excellent in corrosion resistance is useful in a case in which the back surface electrode 14 in contact with the encapsulant 15 is a metal layer such as silver, aluminum, titanium and molybdenum, that is, at least a part of the encapsulant for a solar cell is in contact with the metal layer from the viewpoint of easily exhibiting the effect that the corrosion of the metal component can be further decreased.

Examples of the surface side transparent protective member constituting the solar cell module may include glass, an acrylic resin, polycarbonate, polyester and a fluorine-containing resin. Among these, glass is preferable from the viewpoint of moisture barrier properties and cost. In addition, as the back surface side protective member, a single-layer or multilayer sheet of a metal, various kinds of thermoplastic resin films or the like can be mentioned, and specific examples thereof may include a single-layer or multilayer sheet of a metal such as tin, aluminum and stainless steel, an inorganic material such as glass, polyester, inorganic vapor deposited polyester, a fluorine-containing resin, polyolefin and the like. Among these, glass is preferable from the viewpoint of moisture barrier properties and cost.

In the present invention, the ends of the solar cell module may be subjected to a waterproof sealing treatment using silicone rubber, butyl rubber and the like in order to further suppress the discoloration due to the corrosion of the metal. However, it is preferable to use as a frameless configuration without subjecting the ends to the waterproof sealing treatment from the viewpoint of cost reduction. The encapsulant for a solar cell of the present invention is excellent in corrosion resistance, and thus the encapsulant is especially usefully used for such a frameless configuration. Moreover, the encapsulant is also excellent in impact resistance, and thus it is not necessary to use expensive thermally tempered glass even in the case of employing the frameless configuration.

For the manufacture of the solar cell module, a film of the encapsulant for a solar cell of the present invention is fabricated in advance and it is possible to form a module having the configuration already described by a method known in the art in which the module is pressed at a temperature at which the encapsulant for a solar cell can melt.

In the case of using a vacuum laminating apparatus, for example, a method to laminate the module at a temperature of from 100 to 200°C, particularly from 130 to 170°C under a reduced pressure of from 1 to 30,000 Pa using a known apparatus used for the manufacture of a solar cell module is exemplified. Specifically, in the case of using a vacuum bag or a vacuum ring, it is preferable to laminate the module at from 130 to 170°C under a pressure of about 20,000 Pa as described in EP 1235683 B, for example.

In the case of using a nip roll, for example, a method to conduct the first temporary press of the module at a temperature equal to or lower than the flow beginning temperature of polyvinyl acetal and then to conduct the temporary press thereof under the condition close to the flow beginning temperature can be mentioned. Specifically, the module may be heated at from 30 to 100°C using an infrared heater or the like, and then degassed using a roll, further heated at from 50 to 150°C and then pressed using a roll.

The autoclaving step additionally conducted after the temporary press is carried out, for example, at a temperature of from 130 to 155°C for about 2 hours under a pressure of about from 1 to 1.5 MPa although it may vary depending on the thickness or configuration of the solar cell module.

The solar cell module in which the encapsulant for a solar cell of the present invention is used can also be used as a member of a window, a wall, a roof, a sunroom, a soundproof wall, a show window, a balcony, a handrail and the like, a partition glass member of a conference room and the like and a member of home appliances and the like. In addition, the solar cell module can also be applied to a photovoltaic power plant by installing on a massive scale.

The laminated glass in which the interlayer film for laminated glass of the present invention is used is one obtained by inserting the interlayer film for laminated glass of the present invention between two or more sheets of glass including inorganic glass or organic glass and laminating them. In particular, the interlayer film for laminated glass of the present invention is excellent in transparency, load bearing characteristics, weather resistance, impact resistance, and corrosion resistance, and thus it is also useful for laminated glass in which at least a part of such an interlayer film for laminated glass is in contact with a functional material.

As the functional material, a material containing a metal is preferable and examples thereof may include a heat sensor, a light sensor, a pressure sensor, a thin film capacitive sensor, a liquid crystal display film, an electrochromic functional film, a heat shielding material, an electroluminescent functional film, a light emitting diode, a camera, an IC tag, an antenna, and an electrode, a wire and the like for connecting them.

The glass used for fabricating laminated glass using the interlayer film for laminated glass of the present invention is not particularly limited, and organic glass known in the art may be used, such as polymethyl methacrylate and polycarbonate in addition to inorganic glass such as float plate glass, polished plate glass, figured glass, wired-reinforced plate glass and heat-ray absorbing plate glass, and they may be colorless, colored, transparent or non-transparent. One kind of such glass may be used singly or two or more kinds thereof may be used in combination. In addition, the thickness of the glass is not particularly limited, but it is preferably 100 mm or less.

EXAMPLES

Hereinbelow, the present invention will be specifically described with reference to Examples, but the present invention is not limited to these Examples. Meanwhile, in Preparation Examples, Examples, and Comparative Examples, measurement was carried out according to the following method for the rubbery polymer latex, enlarged rubbery copolymer latex, rubber-containing graft polymer latex, rubber-containing graft polymer powder, which are either prepared or used.

(Refractive index of rubber-containing graft polymer powder)

Refractive index of the rubber-containing graft polymer was measured on the basis of Method A of JIS K 7142. The results are shown in Table 3 and Table 4.

(Content of calcium ions in rubber-containing graft polymer powder)

According to combustion at the maximum temperature of 650°C, 1 g of the rubber-containing graft polymer powder was subjected to dry ashing. The ash was dissolved in 5 ml of concentrated hydrochloric acid and messed up to 50 ml using purified water to give a sample. It was then measured by using an ICP emission spectrophotometric analyzer (IRIS Intrepid II XSP: manufactured by Thermo Fisher Scientific Inc.). Content of calcium ions was obtained based on the measurement. The results are shown in Table 1, Table 3, and Table 4.

(Volume average particle diameter)

The volume average particle diameter of the rubbery polymer latex, enlarged rubbery copolymer latex, and rubber-containing graft polymer latex was measured by using a particle diameter measuring instrument ELS800 manufactured by Otsuka Electronics Co., Ltd. The concentration of the rubber-containing graft polymer latex was adjusted to be approximately 0.1% and subjected to the measurement after further dilution if necessary.

(Preparation Example 1: Method for preparing rubber-containing graft polymer powder)

[Preparation of rubbery polymer latex]

Oxygen contained in the substances other than 1,3-butadiene was substituted with nitrogen to obtain a state in which the polymerization reaction is not substantially inhibited. Thereafter, 60 parts of butyl acrylate, 40 parts of 1,3-butadiene, 0.2 parts of diisopropylbenzene peroxide, 1 part of potassium tallowate, 0.5 parts of sodium N-lauroyl sarcosinate, 0.5 parts of sodium pyrophosphate, 0.005 parts of ferrous sulfate, 0.3 parts of dextrose and 200 parts of deionized water were introduced into an autoclave and the polymerization was conducted at 50°C over 9 hours. As a result, rubbery polymer latex having a conversion rate of monomer of about 97% and a volume average particle diameter of from 0.07 to 0.08 $\mu$m was obtained.

[Preparation of acid group-containing copolymer latex for enlargement]

Into a reaction vessel, 0.003 parts of ferrous sulfate, 0.009 parts of sodium ethylenediamine tetraacetate, 0.3 parts of sodium formaldehyde sulfoxylate, 1.725 parts of potassium tallowate, 2.5 parts of sodium dialkylsulfosuccinate and 200 parts of deionized water were added, the internal temperature thereof was raised to 60°C, and then a mixture consisting of 85 parts of butyl acrylate, 15 parts of methacrylic acid and 0.5 parts of cumene hydroperoxide was continuously added thereto dropwise over 2 hours to conduct the polymerization. The stirring was further continued for 2 hours, thereby obtaining acid group-containing copolymer latex having a conversion rate of monomer of 97% or more.

[Preparation of rubber-containing graft polymer latex]

To a reaction vessel into which the rubbery polymer latex containing 100 parts of polymer solid matter of the rubbery polymer latex had been introduced, 37 parts of deionized water was added, the internal temperature thereof was raised to 40°C, and the pH was adjusted to be from 7 to 8 with a 4.5% aqueous solution of sodium hydroxide. Thereafter, 2.9 parts of the acid group-containing copolymer latex was added thereto and held for 30 minutes, and 0.33 parts of sodium sulfate was added thereto and further held for 10 minutes, thereby obtaining an enlarged rubbery polymer latex. The volume average particle diameter at this time was 0.280 $\mu$m.

To the above, 0.15 parts of sodium formaldehyde sulfoxylate, 0.00004 parts of ferrous sulfate, 0.00013 parts of sodium ethylenediamine tetraacetate and 0.50 parts of sodium N-lauroyl sarcosinate were added, the internal temperature thereof was raised to 80°C, and a mixture consisting of 35.2 parts of methyl methacrylate, 4.8 parts of ethyl acrylate, 0.20 parts of N-octylmercaptan and 0.060 parts of t-butyl hydroperoxide was then started to be added thereto at the time at which the internal temperature thereof reached 60°C, and the mixture was continuously added dropwise over 1 hour to conduct the polymerization. The conversion rate of methyl methacrylate reached almost 100% by further continuing stirring for 90 minutes. The volume average particle diameter of the rubber-containing graft polymer latex thus obtained was 0.288 $\mu$m.

[Preparation of rubber-containing graft polymer latex in powder form]

An aqueous solution consisting of 150 parts by mass of distilled water and 0.6 parts by mass of sulfuric acid was heated to 50°C, and then 100 parts by mass of the above rubber-containing graft polymer latex were added thereto under stirring. After the addition, the temperature was raised to 80°C and maintained for 10 minutes for coagulation. After washing and dehydration, it was dried at 60°C for 24 hours, thereby obtaining a rubber-containing graft polymer powder (A1) with white color. Content of calcium ions in this rubber-containing graft polymer powder was 0.8 ppm or less.

(Preparation Examples 2 to 5: Method for preparing rubber-containing graft polymer powder)

The rubber-containing graft polymer powder (A2 to A5) was obtained in the same manner as Preparation Example 1 except that the use amount of sulfuric acid and calcium acetate, which are a coagulant used for preparing powder, was modified to those described in Table 1. Content of calcium ions in each rubber-containing graft polymer powder is shown in Table 1.

[Table 1]

|  | Preparation Example 1 | Preparation Example 2 | Preparation Example 3 | Preparation Example 4 | Preparation Example 5 |
|---|---|---|---|---|---|
| Type of rubber-containing graft polymer powder | A1 | A2 | A3 | A4 | A5 |
| Rubber-containing graft polymer latex (parts by mass) | 100 | 100 | 100 | 100 | 100 |

(continued)

|  | | Preparation Example 1 | Preparation Example 2 | Preparation Example 3 | Preparation Example 4 | Preparation Example 5 |
|---|---|---|---|---|---|---|
| Coagulant | Sulfuric acid (parts by mass) | 0.6 | 0.4 | 0.2 | 0.1 | 0.0 |
| | Calcium acetate (parts by mass) | 0.0 | 0.6 | 0.9 | 1.2 | 3.1 |
| Amount of calcium ions (ppm) | | < 0.8 | 27 | 280 | 390 | 1100 |

(Preparation Example 6: Polyvinyl acetal)

Into a 2 $m^3$ reaction vessel equipped with a stirrer, 1700 kg of a 7.5% by mass aqueous solution of PVA (average degree of polymerization of 1000, degree of saponification of 99% by mole), 74.6 kg of butyraldehyde and 0.13 kg of 2,6-di-t-butyl-4-methylphenol were introduced and the whole was cooled to 14°C. To this, 160.1 L of an aqueous solution of nitric acid having a concentration of 20% by mass was added, and the butyralization of PVA was initiated. The temperature was started to be raised in 10 minutes after the addition was completed and raised to 65°C over 90 minutes, and the reaction was further conducted for 120 minutes. Thereafter, the resultant was cooled to room temperature and PVB (polyvinyl butyral) precipitated was filtered and then washed 10 times with ion-exchanged water having a quantity of 10 times as much as PVB. Thereafter, PVB was sufficiently neutralized using 0.3% by mass aqueous solution of sodium hydroxide, washed 10 times with ion-exchanged water having a quantity of 10 times as much as PVB, dehydrated and then dried, thereby obtaining PVB. The obtained PVB was used for measuring a refractive index based on Method A of JIS K 7142. As a result, the refractive index was found to be 1.491.

(Example 1)

To 100 parts by mass of PVB (PVB-1) which has been synthesized in Preparation Example 6, 11 parts by mass of the rubber-containing graft polymer powder obtained in Preparation Example 1 were added. In addition, based on the amount of the PVB, 400 ppm of an antioxidant was added. Then, by using a known extruder, a polyvinyl butyral film with thickness of 0.38 mm was prepared at conditions including resin temperature of 200°C at the time of extrusion.

[Content of alkali metal ions and alkali earth metal ions in polyvinyl butyral film]

According to combustion at maximum temperature of 650°C, 1 g of the obtained polyvinyl butyral film was subjected to dry ashing. The ash was dissolved in 5 ml of concentrated hydrochloric acid and messed up to 50 ml using purified water to give a sample. It was then measured by using an ICP emission spectrophotometric analyzer (IRIS Intrepid II XSP: manufactured by Thermo Fisher Scientific Inc.). Total content of the alkali metal ions and alkali earth metal ions was obtained based on the measurement. In addition, overall content of calcium ions was obtained. The results are shown in Table 3.

[Evaluation of physical properties (pummel test)]

Humidity was adjusted at 23°C, 65% RH for 24 hours and then the moisture content of the obtained polyvinyl butyral film was adjusted to 1.5%. Subsequently, commercially available float glass (thickness: 3.0 mm, size: height 300 mm x width 300 mm) was overlaid to have float glass/2 pieces of polyvinyl butyral film/float glass. By adding it to a vacuum bag and treatment at 100°C, -0.09 MPa (gauge pressure), prelamination was performed. Then, according to a treatment at 160°C, 1.0 MPa (gauge pressure) using an autoclave, laminated glass was produced. After that, the laminated glass was allowed to stand for 4 hours at the temperature of -18°C, and by smashing it with a hammer which has a head part weight of 0.45 kg, the glass was pulverized until the particle diameter of the glass becomes 6 mm or less. Glass pieces separated from the polyvinyl butyral film was shaken off and, based on exposure rate (%) of an interlayer film, a pummel value was obtained according to the criteria given in Table 2. The results are shown in Table 3. A higher pummel value indicates higher adhesion of the plasticized film to the glass plate. As described herein, the exposure rate indicates a ratio of an exposed part of the interlayer film resulting from separation of glass pieces relative to the entire area of the interlayer film.

[Table 2]

| Exposure rate of interlayer film (%) | Pummel value |
|---|---|
| 100 | 0 |
| 95 | 1 |
| 90 | 2 |
| 85 | 3 |
| 60 | 4 |
| 40 | 5 |
| 20 | 6 |
| 10 | 7 |
| 5 | 8 |
| 2 | 9 |
| 0 | 10 |

[Evaluation of physical properties (haze)]

A laminated glass was prepared in the same manner as the pummel test. The haze was measured by using the prepared laminated glass on the basis of JIS K 7136. The measurement results are shown in Table 3.

[Evaluation of physical properties (elution amount of acidic component)]

With the obtained polyvinyl butyral film, the elution amount of acidic component after hot water test was measured based on Formula (1).
[Mathematical Formula 1]

$$(\text{Elution amount of acidic component after hot water test}) = A \quad (1)$$

[in Formula (1), A (unit: KOHmg/g) represents a value obtained by dividing a mass (unit: mg) of potassium hydroxide required to neutralize an acidic component present in water after immersing the polyvinyl butyral film as a measurement subject in hot water having a mass of 10 times as much as the polyvinyl butyral film and having a temperature of 85°C for 1000 hours by a mass (unit: g) of the polyvinyl butyral film before being immersed]. The results are shown in Table 3.

[Evaluation of physical properties (length of a discolored part)]

As shown in Fig. 1, on top of a glass substrate 11 which has a size of 100 mm x 100 mm and a thickness of 4 mm, $SnO_2$ film with a thickness of about 700 nm was formed as a transparent electrode layer 12 by a CVD method. Next, on the transparent electrode layer 12, an amorphous silicone-based thin film was formed as a photoelectric conversion unit 13 on the entire substrate surface by using a plasma CVD device. Herein, there are an amorphous Si film of p layer as p-type layer 13a (film thickness of about 15 nm), an amorphous Si film of i layer as i-type layer 13b (film thickness of about 500 nm), and an amorphous Si film of n layer as n-type layer 13c (film thickness of about 3 nm). Next, as a back surface electrode 14, a ZnO film (film thickness of about 80 nm) and an Ag film (film thickness of about 200 nm) were formed on the entire substrate surface by a sputtering method, and a solar cell was formed on top of the glass substrate.
The solar cell formed on glass substrate was placed such that the glass plate is in contact with a hot plate of a vacuum laminator (1522N manufactured by Nisshinbo Mechatronics Inc.), and as an encapsulant 15 on the back surface electrode 14, the above PVB film with a size of 100 mm x 100 mm and a glass substrate 16 which has a size of 100 mm x 100 mm and a thickness of 4 mm were overlaid in the order, and a solar cell module was manufactured under the following conditions.

<Conditions>

Temperature of hot plate: 165°C
Time for vacuum treatment: 12 minutes
Press pressure: 50 kPa
Press time: 17 minutes

After exposing the solar cell module obtained as described above to conditions including 85°C, 85% RH for 2000 hours, the length of a discolored part from the end of the solar cell, that is, the length of a discolored part after high temperature and high humidity test, was measured.

[Evaluation of physical properties (Reduction rate of conversion efficiency after high temperature and high humidity test)]

A solar cell module was manufactured in the same manner as above except that wirings are formed on the solar cell so as to have a measurement of electric properties. The conversion efficiency before and after exposing this solar cell module to conditions including 85°C, 85% RH for 2000 hours was measured by irradiating reference sun light of AM 1.5, 1000 W/m2. Meanwhile, for the measurement of conversion efficiency, the solar simulator manufactured by Nisshinbo Mechatronics Inc. was used. In addition, when the conversion efficiency before exposure is 100% (reference), reduction rate (%) of the conversion efficiency after the exposure was calculated.

(Example 2)

A polyvinyl butyral film was prepared in the same manner as Example 1 except that 25 ppm of acetic acid and 175 ppm of magnesium acetate are added relative to the total amount of the PVB and rubber-containing graft polymer powder. By using the prepared polyvinyl butyral film, evaluation of various physical properties was performed according to the same method as Example 1. The results are shown in Table 3.

(Examples 3 to 7 and Comparative Examples 1 to 3)

A polyvinyl butyral film was prepared in the same manner as Example 1 except that a rubber-containing graft polymer was added to have the composition described in Table 3 or Table 4 and the total amount of acetic acid and magnesium acetate was added to have the amount described in Table 3 or Table 4 relative to the total amount of the PVB and rubber-containing graft polymer powder. In this case, the mass ratio of the added acetic acid and magnesium acetate was 1 : 7. By using the prepared polyvinyl butyral film, evaluation of various physical properties was performed according to the same method as Example 1. The results are shown in Table 3 and Table 4.

(Comparative Examples 4 and 5)

A polyvinyl butyral film was prepared in the same manner as Example 1 except that, as a rubber-containing graft polymer powder, rubber-containing graft polymer B1(manufactured by MITSUBISHI RAYON CO., LTD.; METABLEN S2006) was used and the total amount of acetic acid and magnesium acetate was added to have the amount described in Table 4 relative to the total amount of the PVB and rubber-containing graft polymer powder. In this case, the mass ratio of the added acetic acid and magnesium acetate was 1:7. By using the prepared polyvinyl butyral film, evaluation of various physical properties was performed according to the same method as Example 1. The results are shown in Table 4.

[Table 3]

| | | Example 1 | Example 2 | Example 3 | Example 4 | Example 5 | Example 6 | Example 7 |
|---|---|---|---|---|---|---|---|---|
| Composition of resin composition | PVB resin (parts bv mass) | 100 | 100 | 100 | 100 | 100 | 100 | 100 |
| | Rubber-containing graft polymerization powder A1 (parts by mass) | 11 | 11 | 33 | - | - | - | - |
| | Rubber-containing graft polymerization powder A2 (parts by mass) | - | - | - | 33 | - | - | - |
| | Rubber-containing graft polymerization powder A3 (parts by mass) | - | - | - | - | 33 | - | - |
| | Rubber-containing graft polymerization powder A4 (parts by mass) | - | - | - | - | - | 11 | 33 |
| | Rubber-containing graft polymerization powder A5 (parts by mass) | - | - | - | - | - | - | - |
| | Rubber-containing graft polymerization powder B1 (parts by mass) | - | - | - | - | - | - | - |
| | Total amount of acetic acid and magnesium acetate (ppm) | 0 | 200 | 200 | 200 | 200 | 200 | 200 |
| Rubber-containing graft polymer powder | Refractive index of rubber-containing graft polymer powder | 1.487 | 1.487 | 1.487 | 1.487 | 1.487 | 1.487 | 1.487 |
| | Amount of Ca ions (ppm) | < 0.8 | < 0.8 | < 0.8 | 27 | 280 | 390 | 390 |

(continued)

| | | Example 1 | Example 2 | Example 3 | Example 4 | Example 5 | Example 6 | Example 7 |
|---|---|---|---|---|---|---|---|---|
| | Haze | 1 | 1 | 1 | 1 | 1 | 1 | 1 |
| | Amount of Ca ions (ppm) | < 0.8 | < 0.8 | < 0.8 | 7 | 70 | 39 | 98 |
| | Total amount of alkali metal ions and alkali earth metal ions (μpm) | 50 | 250 | 250 | 257 | 320 | 289 | 348 |
| | Pummel value | 10 | 10 | 10 | 10 | 8 | 10 | 10 |
| PVB film | Elution amount of acidic component after hot water test (KOHmg/g) | 2.53 | 1.31 | - | - | - | 0.85 | - |
| | The length of a discolored part after high temperature and high humidity test (mm) | 3.0 | 2.0 | 2.5 | - | - | 3.0 | - |
| | Reduction rate of conversion efficiency after high temperature and high humidity test (%) | 1 | 0 | 0 | - | - | 1 | - |

[Table 4]

| | | Comparative Example 1 | Comparative Example 2 | Comparative Example 3 | Comparative Example 4 | Comparative Example 5 |
|---|---|---|---|---|---|---|
| Composition of resin composition | PVB resin (parts by mass) | 100 | 100 | 100 | 100 | 100 |
| | Rubber-containing graft polymerization powder A1 (parts bv mass) | - | - | - | - | - |
| | Rubber-containing graft polymerization powder A2 (parts by mass) | - | - | - | - | - |
| | Rubber-containing graft polymerization powder A3 (parts by mass) | - | - | - | - | - |
| | Rubber-containing graft polymerization powder A4 (parts bv mass) | - | - | - | - | - |
| | Rubber-containing graft polymerization powder A5 (parts by mass) | 11 | 11 | 33 | - | - |
| | Rubber-containing graft polymerization powder B 1 (parts bv mass) | - | - | - | 11 | 11 |
| | Total amount of acetic acid and magnesium acetate (ppm) | 0 | 200 | 200 | 200 | 1000 |
| Rubber-containing graft polymer powder | Refractive index of rubber-containing graft polymer powder | 1.487 | 1.487 | 1.487 | 1.460 | 1.460 |
| | Amount of Ca ions (ppm) | 1100 | 1100 | 1100 | 300 | 300 |

(continued)

| | | Comparative Example 1 | Comparative Example 2 | Comparative Example 3 | Comparative Example 4 | Comparative Example 5 |
|---|---|---|---|---|---|---|
| PVB film | Haze | 1 | 1 | 1 | 23 | 23 |
| | Amount of Ca ions (ppm) | 110 | 110 | 2'75 | 30 | 30 |
| | Total amount of alkali metal ions and alkali earth metal ions (ppm) | 160 | 360 | 525 | 230 | 1125 |
| | Pummel value | 2 | 1 | 1 | 10 | 6 |
| | Elution amount of acidic component after hot water test (KOHmg/g) | 0.25 | 0.46 | - | 11.3 | 8.7 |
| | The length of a discolored part after high temperature and high humidity test (mm) | 4.5 | 4.5 | - | 5.0 | 5.5 |
| | Reduction rate of conversion efficiency after high temperature and high humidity test (%) | 4 | 4 | - | 4 | 6 |

As it is evident from Table 4, Comparative Examples 1 to 3 in which calcium ions are contained at prescribed amount or more exhibited a very low pummel value, that is, 1 to 2, according to the pummel test. Thus, it was found that the adhesive property between the polyvinyl butyral film and glass was very poor. Furthermore, Comparative Example 5 in which alkali metal ions and alkali earth metal ions are contained at prescribed amount or more exhibited a pummel value of 6. Thus, it was found to have a poor adhesive property. On the other hand, the films of Examples 1 to 7 in which calcium ions are contained at prescribed amount or less and the rubber-containing graft polymer powder to be used has a refractive index within a prescribed range exhibited excellent transparency, and any of the films showed a pummel test value of 8 or higher, indicating a very good adhesive property to glass. Furthermore, when used as an encapsulant for a solar cell, the film of the present invention exhibited a short length of a discolored part after a high temperature and high humidity test and also a low reduction rate of conversion efficiency after a high temperature and high humidity test. It was also found that the film of Example 2 containing magnesium ions had a suppressed acid value and a short length of a discolored part after a high temperature and high humidity test.

Reference Signs List

| 11 | GLASS SUBSTRATE |
|----|----|
| 12 | TRANSPARENT ELECTRODE LAYER |
| 13 | PHOTOELECTRIC CONVERSION UNIT |
| 13a | p-TYPE LAYER |
| 13b | i-TYPE LAYER |
| 13c | n-TYPE LAYER |
| 14 | BACK SURFACE ELECTRODE |
| 15 | ENCAPSULANT |
| 16 | GLASS SUBSTRATE |

**Claims**

1. A film comprising:

   a resin composition comprising polyvinyl acetal and a rubber-containing graft polymer powder having a refractive index of 1.469 to 1.519;
   0 to 100 ppm of calcium ions; and
   1 to 1100 ppm of alkali metal ions and alkali earth metal ions in total.

2. The film according to claim 1, wherein content of the rubber-containing graft polymer powder is 1 to 100 parts by mass relative to 100 parts by mass of the polyvinyl acetal in the resin composition.

3. The film according to claim 1 or 2, wherein the resin composition further contains magnesium salts.

4. The film according to any one of claims 1 to 3, wherein content of the calcium ions in the rubber-containing graft polymer powder is 0 to 1000 ppm.

5. A resin composition for a film in which a difference in refractive index is ±0.02 or less between polyvinyl acetal and a rubber-containing graft polymer powder, wherein the resin composition contains 0 to 100 ppm of calcium ions and 1 to 1100 ppm of a total of alkali metal ions and alkali earth metal ions.

6. A rubber-containing graft polymer powder for a polyvinyl acetal resin film which has calcium ion content of 0 to 750 ppm and a refractive index of 1.469 to 1.519.

7. The rubber-containing graft polymer powder for a polyvinyl acetal resin film according to claim 6, wherein the rubber-containing graft polymer powder for a polyvinyl acetal resin film is obtained by coagulating a rubber-containing graft polymer latex, which is obtained by graft polymerization of a vinyl monomer (Y) in the presence of a rubbery polymer (X), using a coagulant containing at least one selected from an inorganic acid, an organic acid, an alkali metal salt of an inorganic acid or an organic acid, and an aluminum salt of an inorganic acid or an organic acid, and then by recovering it.

8. The rubber-containing graft polymer powder for a polyvinyl acetal resin film according to claim 7, wherein the rubbery polymer (X) contains a conjugated diene unit (x1).

9. The rubber-containing graft polymer powder for a polyvinyl acetal resin film according to claim 8, wherein the rubbery polymer (X) contains 25 to 75% by mass of a conjugated diene unit (x1), 75 to 25% by mass of an acrylic acid alkyl ester unit (x2) having an alkyl group with 2 to 8 carbon atoms, and 0 to 5% by mass of other copolymerizable monomer unit (x3).

10. The rubber-containing graft polymer powder for a polyvinyl acetal resin film according to any one of claims 7 to 9, wherein the vinyl monomer (Y) contains 50 to 100% by mass of a methyl methacrylate (y1) and 50 to 0% by mass of an acrylic acid alkyl ester having an alkyl group with 1 to 8 carbon atoms and/or styrene (y2).

11. The rubber-containing graft polymer powder for a polyvinyl acetal resin film according to any one of claims 7 to 10, wherein the rubber-containing graft polymer powder for a polyvinyl acetal resin film is obtained by graft polymerization of 10 to 1000 parts by mass of the vinyl monomer (Y) in the presence of 100 parts by mass of a polymer solid matter of the rubbery polymer (X).

12. A resin composition containing the rubber-containing graft polymer powder for a polyvinyl acetal resin film according to any one of claims 6 to 11 and polyvinyl acetal.

13. A film comprising the resin composition according to claim 12.

14. An interlayer film for laminated glass or an encapsulant for a solar cell having the film according to any one of claims 1 to 4.

15. A laminated glass or a photovoltaic module which is prepared with the interlayer film for laminated glass or encapsulant for a solar cell according to claim 14.

# FIG. 1

- 1 1
- 1 2
- 1 3 a
- 1 3 b  } 1 3
- 1 3 c
- 1 4
- 1 5
- 1 6

## INTERNATIONAL SEARCH REPORT

| | International application No. |
|---|---|
| | PCT/JP2015/067369 |

**A. CLASSIFICATION OF SUBJECT MATTER**
*C08J5/18*(2006.01)i, *C03C27/12*(2006.01)i, *C08J3/16*(2006.01)i, *C08L29/14* (2006.01)i, *C08L51/04*(2006.01)i, *H01L31/048*(2014.01)i

According to International Patent Classification (IPC) or to both national classification and IPC

**B. FIELDS SEARCHED**

Minimum documentation searched (classification system followed by classification symbols)
C08J3/00-5/24, C03C27/00-27/12, C08L1/00-101/16, H01L31/00-31/20

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | WO 2012/026393 A1 (Kuraray Co., Ltd.),<br>01 March 2012 (01.03.2012),<br>claims; paragraphs [0039] to [0059]; examples;<br>drawings<br>& CN 103080035 A        & EP 2610225 A1<br>& KR 10-2013-0100777 A   & TW 201213115 A<br>& US 2014/0014178 A1 | 1-7,10-15<br>8-9 |
| A | WO 03/011788 A1 (Kaneka Corp.),<br>13 February 2003 (13.02.2003),<br>claims; examples<br>& JP 2003-40654 A | 1-15 |

| ☒ | Further documents are listed in the continuation of Box C. | ☐ | See patent family annex. |
|---|---|---|---|

| | |
|---|---|
| * Special categories of cited documents: | "T" later document published after the international filing date or priority date and not in conflict with the application but cited to understand the principle or theory underlying the invention |
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 04 September 2015 (04.09.15) | 15 September 2015 (15.09.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

**INTERNATIONAL SEARCH REPORT**

International application No.

PCT/JP2015/067369

C (Continuation). DOCUMENTS CONSIDERED TO BE RELEVANT

| Category* | Citation of document, with indication, where appropriate, of the relevant passages | Relevant to claim No. |
|---|---|---|
| P,X | WO 2014/097962 A1 (Kuraray Co., Ltd. et al.), 26 June 2014 (26.06.2014), claims; paragraphs [0033] to [0094]; examples; drawings & TW 201437243 A | 1-15 |
| P,A | JP 2015-8285 A (Kuraray Co., Ltd.), 15 January 2015 (15.01.2015), claims; examples; drawings (Family: none) | 1-15 |

Form PCT/ISA/210 (continuation of second sheet) (July 2009)

**REFERENCES CITED IN THE DESCRIPTION**

**Patent documents cited in the description**

- JP 2006013505 A
- WO 2009151952 A
- WO 2012026393 A
- JP 2003040654 A
- WO 03033583 A
- EP 1235683 B